(19) Europäisches Patentamt
European Patent Office
Office européen des brevets

(11) **EP 4 753 146 A1**

(12) **EUROPEAN PATENT APPLICATION**

(43) Date of publication:
**03.06.2026 Bulletin 2026/23**

(21) Application number: **25214719.4**

(22) Date of filing: **10.11.2025**

(51) International Patent Classification (IPC):
**H03F 1/30** (2006.01)      **H03F 3/30** (2006.01)

(52) Cooperative Patent Classification (CPC):
**H03F 3/3028; H03F 1/308**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **29.11.2024 US 202418964236**

(71) Applicant: **STMicroelectronics International N.V.
1228 Plan-les-Ouates, Geneva (CH)**

(72) Inventors:
• **CALCAGNO, Giuseppe**
  **I-98168 Messina (IT)**
• **MESSINA, Benedetta**
  **I-95030 Mascalucia (Catania) (IT)**
• **DAIDONE, Antonio**
  **I-95037 San Giovanni La Punta (Catania) (IT)**

(74) Representative: **Buzzi, Notaro & Antonielli d'Oulx S.p.A.
Corso Vittorio Emanuele II, 6
10123 Torino (IT)**

(54) **CLASS AB QUIESCENT CURRENT OPTIMIZATION**

(57)      Embodiments of the present disclosure provide techniques for optimizing quiescent current in an amplifier. The amplifier (100) may include an output stage (132, 134) associated with a quiescent current (140, Iqs); a set of NMOS transistors comprising a first NMOS transistor (118) and a second NMOS transistor (116) connected together. The first NMOS transistor (118) may have a first bias current (125). The amplifier (100) may further include a first set of PMOS transistors comprising a first PMOS transistor (122) and a second PMOS transistor (120). The first PMOS transistor (122) may have a second bias current (123). The amplifier may further include an optimization circuit (111). The optimization circuit may include a current steering circuit (130) that is driven by a threshold current (129). The optimization circuit may further include a level shifting device (124) connected to the current steering circuit (130). The current steering circuit may be configured to adjust the first bias current (125) based on the threshold current (129).

FIG. 1

## Description

### FIELD OF THE INVENTION

Example embodiments of the present disclosure relate to amplifiers and, more particularly, to quiescent current optimization in class AB amplifiers.

### BACKGROUND

Applicant has identified many technical challenges and difficulties associated with quiescent current in class AB amplifiers. Through applied effort, ingenuity, and innovation, Applicant has solved many of these identified problems by developing the embodiments of the present disclosure, which are described in detail below.

### BRIEF SUMMARY

Various embodiments described herein relate to amplifiers and, more particularly, to quiescent current optimization in class AB amplifiers.

In accordance with one aspect of the present disclosure, an amplifier is provided. In some embodiments, the amplifier includes an output stage associated with a quiescent current; a set of NMOS transistors comprising a first NMOS transistor and a second NMOS transistor connected together, the first NMOS transistor having a first bias current; a first set of PMOS transistors comprising a first PMOS transistor and a second PMOS transistor, the first PMOS transistor having a second bias current; and an optimization circuit comprising: a current steering circuit that is driven by a threshold current, the current steering circuit comprising a second set of PMOS transistors; and a level shifting device connected to the current steering circuit, wherein, the current steering circuit is configured to, in response to a first condition of one or more conditions, adjust the first bias current proportionally with a supply voltage by reducing the first bias current by an amount corresponding to the threshold current.

In some embodiments, the first bias current is the same as the second bias current.

In some embodiments, the level shifting device comprises a third NMOS transistor.

In some embodiments, the second set of PMOS transistors comprise a third PMOS transistor and a fourth PMOS transistor connected together.

In some embodiments, a gate of the third PMOS transistor is connected to a source of the third NMOS transistor.

In some embodiments, the one or more conditions include a second condition corresponding to a low supply voltage condition.

In some embodiments, the first condition is determined based on (i) a gate voltage of the third NMOS transistor, (ii) a gate voltage of the fourth PMOS transistor, and (iii) a gate-source voltage of the third NMOS transistor, wherein the first condition is indicative of a high supply voltage condition.

In some embodiments, the set of NMOS transistors generates a first bias voltage corresponding to the gate voltage of the fourth PMOS transistor.

In some embodiments, the first set of PMOS transistors generates a second bias voltage corresponding to the gate voltage of the third NMOS transistor.

In some embodiments, the amplifier further includes a fifth PMOS transistor and a fourth NMOS transistor connected together.

In some embodiments, the amplifier further includes a sixth PMOS transistor for receiving an input signal, wherein the sixth PMOS transistor is connected to the fifth PMOS transistor and the fourth NMOS transistor.

In some embodiments, the output stage comprises a seventh PMOS and fifth NMOS connected together.

In some embodiments, the amplifier is a class AB amplifier.

In some embodiments, the threshold current is configurable.

In some embodiments, the optimization circuit comprises a second current steering circuit.

In accordance with one aspect of the present disclosure, a device is provided. In some embodiments, the device includes an amplifier according to one or more aspects of the present disclosure.

### BRIEF DESCRIPTION OF THE DRAWINGS

Reference will now be made to the accompanying drawings. The components illustrated in the figures may or may not be present in certain embodiments described herein. The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:

FIG. 1 illustrates a circuit diagram of an example class AB amplifier in accordance with at least one example embodiment of the present disclosure.

FIG. 2 illustrates a circuit diagram of an example class AB amplifier under a low supply voltage condition in accordance with at least one example embodiment of the present disclosure.

FIG. 3 illustrates a circuit diagram of an example class AB amplifier under a high supply voltage condition in accordance with at least one example embodiment of the present disclosure.

FIG. 4 illustrates a circuit diagram of another example class AB amplifier in accordance with at least one example embodiment of the present disclosure.

FIG. 5 provides a flow chart depicting operations of an example method for quiescent current optimization in accordance with at least one embodiment.

FIG. 6 provides a graphical representation of a behavior of a current steering circuit in accordance with at least one example embodiment of the present disclosure.

FIG. 7 provides a graphical representation of example quiescent currents over a supply voltage sweep.

## DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

As used herein, the term "or" is used in both the alternative and conjunctive sense, unless otherwise indicated. The terms "illustrative" and "example" are used to be examples with no indication of quality level. Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

Amplifiers are electronic devices or components that increase the amplitude or strength of an input signal, for example without altering the original shape or characteristics of the input signals. Class AB amplifiers may be used in various devices and systems, such as, for example, audio devices and/or systems. Class AB amplifiers are a type of amplifiers that are include features of class A amplifiers and class B amplifiers and overcome some of the deficiencies in class A or class B amplifies, such as, for example, low efficiency in class A amplifiers, cross-over distortion in class B amplifiers. Class AB amplifiers are used in various applications, devices, and/or systems for their capabilities over other amplifiers, including their high efficiency output. For example, class AB amplifiers are often used in analog circuits.

Class AB amplifiers include an output stage that is used to provide source and sink current capability on the output of the class AB amplifier. Class AB amplifiers, particularly the output stage of class AB amplifiers, may be associated with quiescent current consumption, which may limit the performance of the class AB amplifier and the device or system in which they are being used. For example, quiescent current consumption may affect standby power. Accordingly, the control of quiescent current consumption in class AB amplifiers and, particularly, in the output stage of class AB amplifiers is desired and important.

Quiescent current may refer to current consumed by a circuitry in a low-power state. For example, quiescent current may include current drawn by a device over durations in which the device is not coupled to a load or coupled to a low load. In some examples, quiescent current may be referred to as standby current and/or sleep mode current. Quiescent current consumption is dependent on supply voltage variation. For example, the quiescent current consumption may increase with increasing supply voltage over the supply voltage sweep. For example, in traditional class AB amplifier architectures, a supply voltage change from 2.2V to 5.5V may cause a substantial increase and variation in quiescent current consumption. For example, over 20% quiescent current variation may be experienced in traditional class AB amplifiers due to such increase in supply voltage from 2.2V to 5.5V.

Traditional class AB amplifiers and traditional quiescent current control techniques are deficient in effectively controlling quiescent current consumption and variation against changes in the supply voltage. Quiescent current control techniques that rely primarily on matching transistors for current mirroring with the goal of maintaining the current through the transistors so as to set the output current may not account for the effect of variation in the supply voltage (e.g., over the supply voltage sweep) on quiescent current variation. For example, the difference in the drain-source voltage of the output devices at the output stage and their diode bias circuit may be reflective of quiescent current variation induced by changes in the supply voltage. Such difference in drain-source voltage and output device voltage generally results in channel length modulation and the current mirrored in the output will increase with the supply voltage.

Example embodiments of the present disclosure address the above mentioned challenges, difficulties, and deficiencies, as well as other challenges, difficulties, and deficiencies associated with quiescent current consumption and variation in amplifiers, particularly, class AB amplifiers. Example embodiments of the present disclosure use a current steering architecture to bias a driving stage, such as Monticelli stage, of a class AB amplifier to reduce quiescent current variation against the supply voltage. For example, example embodiments of the present disclosure improve current mirroring techniques/technology in class AB amplifiers by implementing a current steering architecture in class AB amplifiers to adjust or otherwise control the current (e.g., bias current) flowing through a transistor(s) at the driving stage of the class AB amplifier which is mirrored at the output stage of the class AB amplifier, such that the quiescent current and quiescent current variation at the output stage of class AB amplifiers is reduced despite variation in supply voltage (e.g., increase in supply voltage). Such transistor may be referred to herein as mirrored transistor. In example embodiments, the class AB amplifier includes at least one current steering circuit that is driven by a threshold current. Example embodiments, using the current steering circuit and based on the threshold current, reduce, adjust, or otherwise control the bias current of such mirrored transistor. In this regard, the mirrored transistor may at least in part set the quiescent current at the output stage of the class AB amplifier. For example, the quiescent current at the output stage of the class AB amplifier may be determined based at least in part on the mirrored transistor. Some example embodiments use the current steering circuit driven by the threshold current (which may be configurable) to reduce or otherwise adjust the bias current of the mirrored transistor by an amount that corresponds to the threshold current. In this regard, example embodiments of the present disclosure provide for effective control of quiescent current variation and consumption such that the quiescent current variation is optimized (e.g., reduced, minimized, mitigated, or similar terms). Some example embodiments include multiple current steering circuits that further optimize the class AB amplifier by further reducing the quiescent current and variation thereof over a supply voltage sweep.

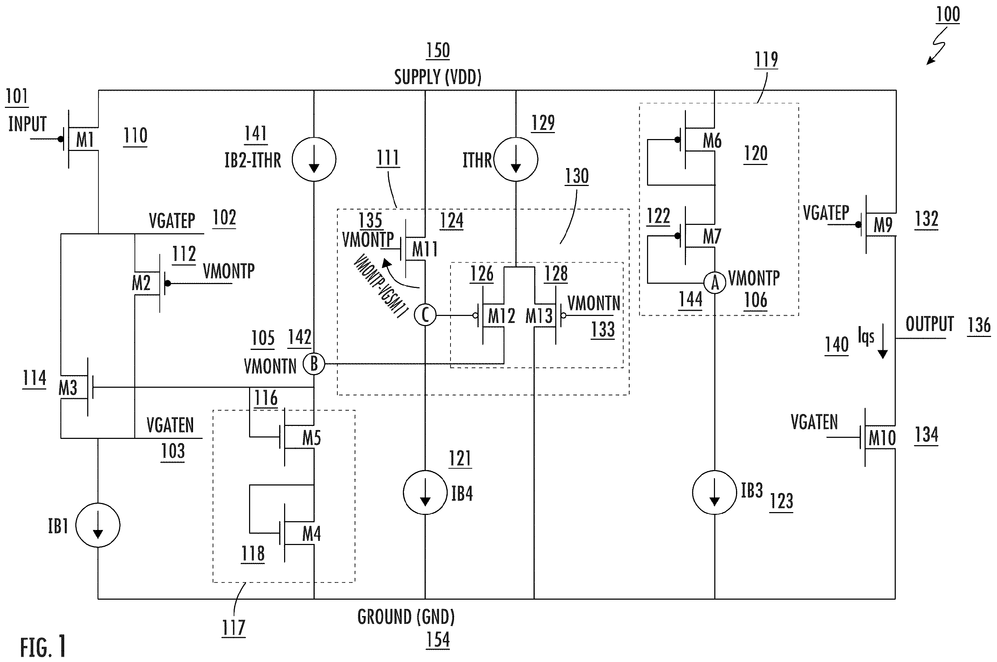

FIG. 1 illustrates a circuit diagram of a class AB amplifier 100 in accordance with at least one example embodiment of the present disclosure.

As shown in FIG. 1, the class AB amplifier 100 includes a p-channel metal oxide semiconductor (PMOS) transistor 110 coupled to a current source. For example, the PMOS transistor 110 may serve as the input terminal of the class AB amplifier 100. As shown in FIG. 1, an input signal 101 (e.g., input current signal) may be provided to the class AB amplifier 100 via the PMOS transistor 110.

The class AB amplifier 100 includes a first output device 132 and a second output device 134 at the output stage of the class AB amplifier. As shown in FIG. 1, the first output device 132 may be embodied as or otherwise comprise a PMOS transistor 132. As further shown in FIG. 1, the second output device 134 may be embodied as or otherwise comprise an n-channel metal oxide semiconductor (NMOS) transistor 134. The first output device 132 and the second output device 134 may define the output node 136 at the output stage of the class AB amplifier 100. As shown in FIG. 1, the NMOS transistor 134 and the PMOS transistor 132 may be coupled together. In some embodiments, the drain of the PMOS transistor 132 is connected to the drain of the NMOS transistor 134 to define the output node 136. As shown in FIG. 1, quiescent current 140 may be generated and/or flow through the first output device 132 and/or second output device 134.

In the illustrated example, the class AB amplifier 100 includes a PMOS transistor 112 connected to an NMOS transistor 114. The PMOS transistor 112 and the NMOS transistor 114 may be connected to the PMOS transistor 110 such that input current (e.g., corresponding to the input current signal) flows through the PMOS transistor 110 to the PMOS transistor 112 and NMOS transistor 114. The PMOS transistor 112 and the NMOS transistor 114 may create floating voltage sources. For example, the PMOS transistor 112 may create a floating voltage source 102 and the NMOS transistor 114 may create a floating voltage source 103. In some embodiments, the PMOS transistor 112 and NMOS transistor 114 may be components of a driving stage of the class AB amplifier.

In some embodiments, the class AB amplifier 100 includes a first pair of diode-stacked devices 117 comprising an NMOS transistor 116 and an NMOS transistor 118. The first pair of diode-stacked devices 117 may be components of the driving stage of the class AB amplifier. The NMOS transistor 116 and the NMOS transistor 118 may be coupled together. In some embodiments, the drain of the NMOS transistor 118 is connected to the source of the NMOS transistor 116. In some embodiments, the gate of the NMOS transistor 118 is connected to a node that connects to the drain of the NMOS transistor 118 and to the source of the NMOS transistor 116. The NMOS transistor 114 may be connected to the NMOS transistor 116. For example, in some embodiments, the gate of the NMOS transistor 114 is connected to a gate and/or drain of the NMOS transistor 116. In some embodiments, the NMOS transistor 116 is connected to a node 142, described further herein. For example, in some embodiments, the drain of the NMOS transistor 116 is connected to the node 142. The first pair of diode-stacked devices 117 may create a bias voltage 105. The bias voltage 105 may be reflected at the node 142. The bias voltage 105 may correspond to the gate voltage 133 of a PMOS transistor 128 (e.g., voltage at the gate of the PMOS transistor 128 of a current steering circuit 130 described further herein). For example, the bias voltage 105 and the gate voltage 133 may be substantially the same (e.g., VMONTN). The NMOS transistor 118 may be coupled to the NMOS transistor 134 (e.g., output device 134). In some embodiments, the source of the NMOS transistor 118 is connected to the source of the NMOS transistor 134 such that the NMOS transistor 118 represents a mirrored transistor. For example, the current of the output device 134 may mirror the current of the NMOS transistor 118. By way of example, the current of the output device 134 may correspond to or otherwise be reflective of the current of the NMOS transistor 118. The class AB amplifier 100 includes a second pair of diode-stacked devices 119 comprising a PMOS transistor 120 and PMOS transistor 122. The second pair of diode-stacked devices 119 may be components of the driving stage of the class AB amplifier. The PMOS transistor 120 and the PMOS transistor 122 may be coupled together. In some embodiments, the source of the PMOS transistor 122 may be connected to the drain of the PMOS transistor 120. In some embodiments, the gate of the PMOS transistor 120 may be connected at a node that connects to the source of the PMOS transistor 122 and to the drain of the PMOS transistor 120. As shown in FIG. 1, the PMOS transistor 122 may be connected to a node 144. For example, in some embodiments, the gate of the PMOS transistor 122 may be connected to the drain of the PMOS transistor 122 at the node 144. In some embodiments, the PMOS transistor 122 is connected to ground 154. The second pair of diode-stacked devices 119 may create a bias voltage 106. The bias voltage may be reflected at the node 144. The bias voltage 106 may correspond to the gate voltage 135 of an NMOS transistor 124 (e.g., voltage at the gate of the NMOS transistor 124). For example, the bias voltage 106 and the gate voltage 135 may be substantially the same (e.g., VMONTP). The PMOS transistor 120 may be coupled to the PMOS transistor 132 (e.g., output device 132). In some embodiments, the source of the PMOS transistor 120 is connected to the source of the PMOS transistor 132. In some embodiments, the current of the first output device 132 mirrors the current of the PMOS transistor 120.

The class AB amplifier 100 includes an optimization circuit 111. In some embodiments, the optimization circuit 111 includes a level shifting device 124 and a current steering circuit 130. In some embodiments, the level shifting device 124 is embodied as or otherwise comprises the NMOS transistor 124. For example, the NMOS transistor 124 may be used for level shifting in the class AB amplifier 100. In some embodiments, level shifting refers to translating signals, such as voltage signals, from one level to another (e.g., between different voltage levels, such as for example, between 3.3V to 5V). In this regard, in such some embodiments, a level shifting device 124 refers to a device that translates signals, such as voltage signals, from one level to another.

The NMOS transistor 124 may be connected to the supply voltage 150 and ground 154. In some embodiments, a bias current 121 may be generated and/or flow through the NMOS transistor 124. The optimization circuit 111 includes a current steering circuit 130 comprising a PMOS transistor 126 and the PMOS transistor 128 that are connected together. For example, the PMOS transistor 126 and the PMOS transistor 128 may be used for current steering in the class AB amplifier 100. In some embodiments, current steering refers to increasing or decreasing current in response to changes to voltage such as, for example, supply voltage or output voltage. For example, current steering may be configured and/or leveraged to direct current through one or more paths in a circuit. In some embodiments, current steering refers to switching the input current from one leg of a current divider. In this regard, a current steering circuit refers to a circuit comprising one or more components configured to perform current steering. In some embodiments, the PMOS transistor 126 and the PMOS transistor 128 are connected together via the respective sources of the PMOS transistor 126 and PMOS transistor 128, which may be connected to the supply voltage 150. For example, in some embodiments, the source of the PMOS transistor 126 is connected to the source of the PMOS transistor 128.

As described above, in some embodiments, the NMOS transistor 118 is coupled to the NMOS output device 134 (e.g., NMOS transistor 134), such that the current at the NMOS transistor 118 is mirrored at the NMOS output device 134. In some embodiments, the quiescent current 140 is set by a ratio defined by the NMOS output device 134 (e.g., embodied as NMOS transistor 134) and the NMOS transistor 118 (e.g., mirrored transistor) of the first pair of diode-stacked devices 117. For example, the quiescent current 140 may be set by the ratio of the NMOS transistor 134 to the NMOS transistor 118.

In some embodiments, to reduce quiescent current variation (and thus reduce quiescent current consumption) with respect to the quiescent current 140, the bias current (IB2) 125 of the NMOS transistor 118 of the first pair of diode-stacked devices 117 is adjusted (e.g., changed, modified, or similar terms) with respect to the supply voltage 150. For example, the bias current through the diode-stacked devices 117 (e.g., through the NMOS transistor 116 and the NMOS transistor 118) may be adjusted proportionally with the supply voltage 150. In some embodiments, the bias current 123 of the PMOS transistor 120 of the second pair of diode-stacked devices 119 is substantially the same as the bias current 125 of the NMOS transistor 118.

The bias current 125 may be adjusted based on a threshold current (ITHR) 129. For example, the threshold current 129 may drive the current steering circuit 130 and/or optimization circuit 111. The current steering circuit 130 may be connected to the supply voltage 150. For example, the PMOS transistor 126 and the PMOS transistor 128 may be connected to the supply voltage 150 and a threshold current 129 (or portion thereof) may flow towards and/or through the PMOS transistor 126 and the PMOS transistor 128 of the current steering circuit 130. In some embodiments, the threshold current 129 is configurable. In various embodiments, the threshold current 129 refers to the current value (e.g., amount of current) by which to deviate the bias current 125 of the diode-stacked devices 117 and/or the NMOS transistor 118 when the supply voltage changes, such as when the supply voltage increases (e.g., increases to a predetermined voltage, such as a threshold voltage).

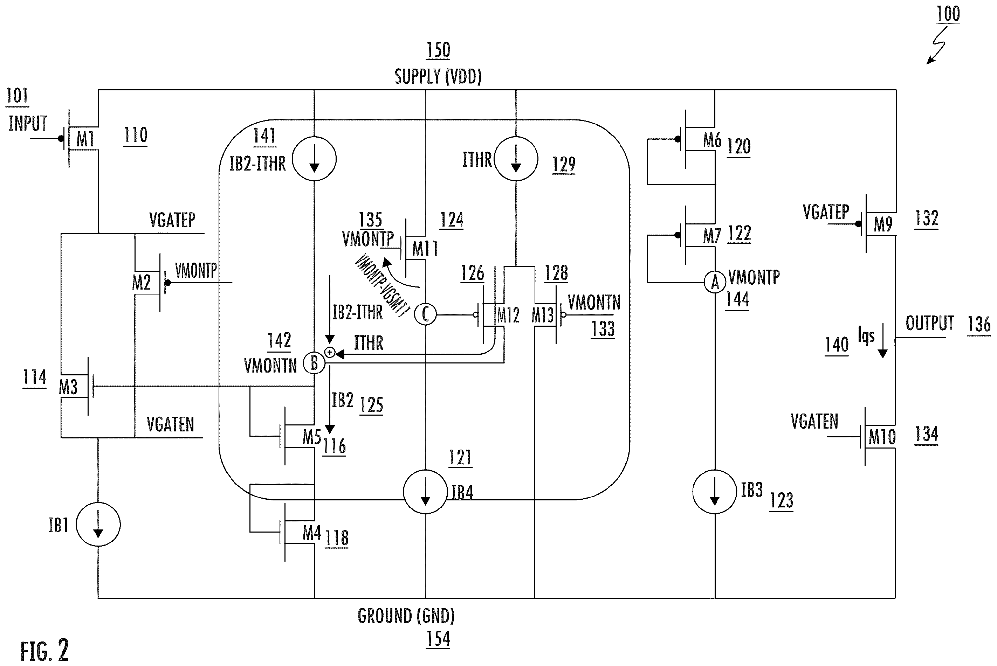

In some embodiments, the bias current 125 is adjusted, such as reduced, by an amount corresponding to the threshold current 129 in response to a change in the supply voltage, such as supply voltage increase and/or in response to one or more conditions. In some embodiments, the bias current 125 of the NMOS transistor 118 is adjusted (e.g., adjusted proportionally) with respect to the supply voltage 150 using the current steering circuit 130. For example, the bias current 125 of the NMOS transistor 118 may be reduced proportionally with the supply voltage 150 using the current steering circuit 130 in response to a change in the supply voltage 150 and/or in response to one or more conditions. In some embodiments, the threshold current 129 may be set or determined based on the desired quiescent current reduction (e.g., desired amount of quiescent current reduction or variation). FIG. 2 illustrates a circuit diagram of an operational example of a class AB amplifier 100 for low supply voltage in accordance with at least one example embodiment of the present disclosure. As shown in FIG. 2, in a low supply voltage operation or condition, the gate voltage (VMONTN) of the PMOS transistor 128 of the current steering circuit 130 is greater than the difference between the gate voltage (VMONTP) of the NMOS transistor 124 and the gate-source voltage (VGS) of the NMOS transistor 124 (e.g., the voltage between the gate and the source of the NMOS transistor 124) representing a level shifting device. For example, in some embodiments, a low supply voltage operation/condition may occur when "VMONTN" is greater than "VMONTP-VGS" (e.g., VMONTN > VMONTP-VGS).

In such low supply voltage operation/condition, as shown, in FIG. 2, the threshold current 129 flows through the PMOS transistor 126 towards the node 142, and the NMOS transistor 118 is biased with the bias current (IB2) 125 without current deviation. For example, the adjusted bias current (IB2-ITHR) 141 and the threshold current (ITHR) are summed at the node 142, whereby the threshold current is canceled out and the bias current 125 flows through the NMOS transistor 118. In some embodiments, the quiescent current 140 for low supply voltage operation/condition may be represented and/or determined based on equation 1 below.

$$Iqs = \frac{W\_M10}{W\_M4} * IB2$$

**Equation 1**

In the equation 1, Iqs may represent the quiescent current, IB2 may represent the bias current of the NMOS transistor 118, and $\frac{W\_M10}{W\_M4}$ may represent the ratio of the output device 134 to the NMOS transistor 118.

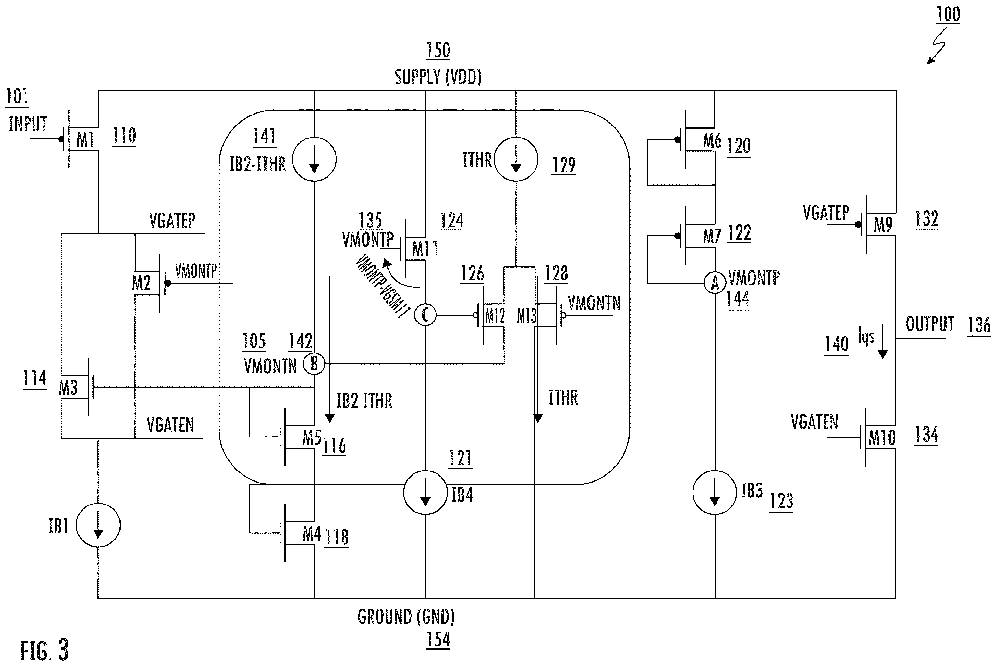

FIG. 3 illustrates a circuit diagram of an operational example of a class AB amplifier 100 for high supply voltage in accordance with at least one example embodiment of the present disclosure. As shown in FIG. 3, in a high supply voltage operation or condition, the gate voltage (VMONTN) of the PMOS transistor 128 of the current steering circuit 130 is less than the difference between the gate voltage (VMONTP) at the NMOS transistor 124 and the gate-source voltage (VGS) of the NMOS transistor 124. For example, in some embodiments, a high supply voltage operation/condition may occur when "VMONTN" is less than "VMONTP-VGS" (e.g., VMONTN < VMONTP-VGS).

In such high supply voltage operation/condition, as shown, in FIG. 3, the threshold current 129 flows through the PMOS transistor 128 (towards ground 154), and the NMOS transistor 118 is biased with a lower bias current (e.g., relative to a low supply voltage condition) by adjusting the bias current 125 by the threshold current 129 amount (e.g., by the operation IB2-ITHR). For example, the adjusted bias current 141(e.g., IB2-ITHR) flows through the NMOS transistors 118. In this regard, the bias current 125 of the NMOS transistor 118 is deviated by an amount that corresponds to the threshold current. In some embodiments, the quiescent current 140 for the high supply voltage operation may be represented and/or determined based on equation 2 below.

$$Iqs = \frac{W\_M10}{W\_M4} * (IB2 - ITHR)$$

<u>Equation 2</u>

In the equation 2, Iqs may represent the quiescent current, (IB2 - ITHR) may represent the adjusted bias current 141, and $\frac{W\_M10}{W\_M4}$ may represent the ratio of the output device 134 to the NMOS transistor 118.

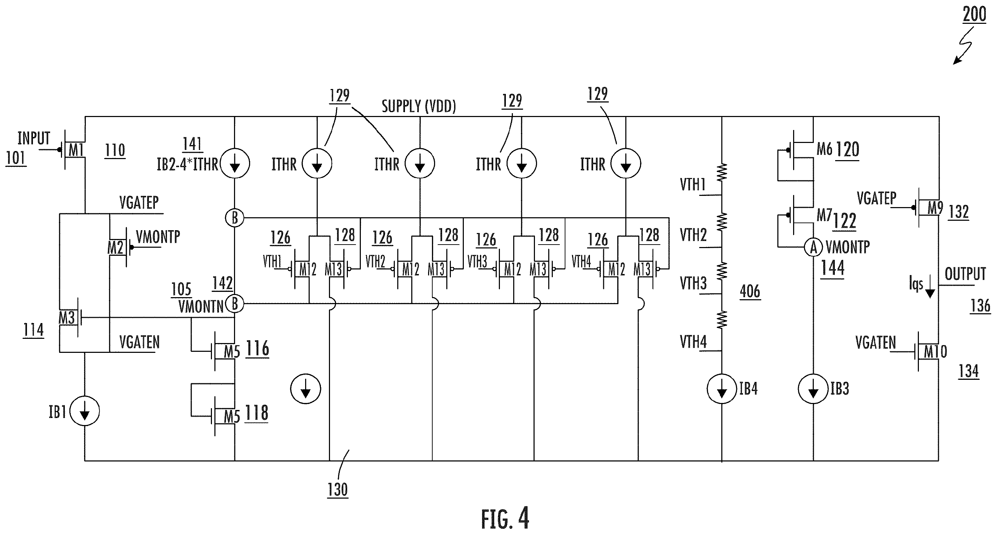

FIG. 4 illustrates a circuit diagram of another example class AB amplifier 200 in accordance with at least one example embodiment of the present disclosure. The example class AB amplifier 200 may include similar components as the class AB amplifier 100.

As shown in FIG. 4, class AB amplifier 200 includes a plurality of current steering circuits 130. Each current steering circuit 130 may be driven by a threshold current 129 which may be different for at least two of the current steering circuits 130. In some embodiments, the threshold current 129 is different for each current steering circuit 130 and/or otherwise may be individually set or configurable. The adjusted bias current 141 may be determined by the operation: [bias current - N * threshold current], where N is an integer and may represent the number of current steering circuits 130. In some embodiments, the threshold current may be set or determined based on the desired quiescent current reduction.

As shown in FIG. 4, the class AB amplifier 200 includes a plurality of resistors dividers 406 that are user to generate the threshold currents. In some embodiments, the threshold currents may be generated using other methods and/or devices.

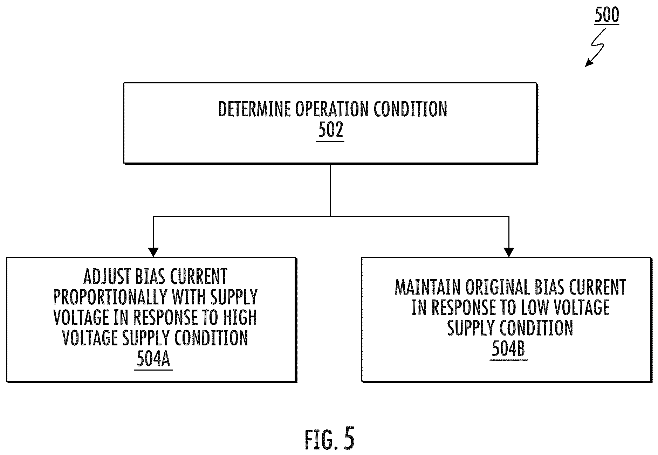

FIG. 5 illustrates a flow chart depicting operations of an example method for class AB amplifier quiescent current optimization in accordance with at least one embodiment of the present disclosure. In some embodiments, the method 500 is performed by one or more specially-configured computing devices, such as an apparatus, device, or system embodying the class AB amplifier 100 or 200 alone or in communication with one or more other component(s), device(s), system(s), and/or the like. In some embodiments, the apparatus, device, or system comprises the class AB amplifier 100 or 200. In some embodiments, the apparatus, device, or system is in communication with one or more external apparatus(es), system(s), device(s), and/or the like, to perform one or more of the operations as depicted and described.

Although the example method 500 depicts a particular sequence of operations, the sequence may be altered without departing from the scope of the present disclosure. For example, some of the operations depicted may be performed in parallel or in a different sequence that does not materially affect the function of the method 500. In other examples, different components of an example apparatus, device, or system that implements the method 500 may perform functions at substantially the same time or in a specific sequence.

According to some examples, the method 500 includes determining an operation condition of one or more operation conditions at block 502. In some examples determining an operation condition comprises determining whether the class AB amplifier 100 or 200 is operating at a low supply voltage or a high supply voltage. In some embodiments, the operation condition is determined based on the level shifting device 124 (e.g., NMOS transistor 124) and/or the current steering circuit 130 of the optimization circuit 111. In some embodiments, the operation condition is determined based on the gate voltage of the level shifting device 124 (e.g., NMOS transistor 124), the gate voltage of the PMOS transistor 128 of the current steering circuit 130, and/or the gate-source voltage of the level shifting device 124 (e.g., NMOS transistor 124).

In some examples, the operation condition is determined as a low supply voltage condition if the gate voltage (VMONTN) of the PMOS transistor 128 of the current steering circuit 130 is greater than the difference between the gate voltage (VMONTP) of the NMOS transistor 124 and the gate-source voltage (VGS) of the NMOS transistor 124 (e.g., if VMONTN > VMONTP-VGS).

In some examples, the operation condition is determined as a high supply voltage condition, if the gate voltage (VMONTN) of the PMOS transistor 128 of the current steering circuit 130 is less than the difference between the gate voltage (VMONTP) at the NMOS transistor 124 and the gate-source voltage (VGS) of the NMOS transistor 124 (e.g., if VMONTN < VMONTP-VGS).

According to some examples, the method 500 includes, at block 504a, in response to a low supply voltage condition, the threshold current 129 flows through the PMOS transistor 126 towards the node 142, and the NMOS transistor 118 is biased with the bias current 125 without current deviation (e.g., without adjusting the bias current 125).

According to some examples, the method 500 includes, at block 504b, in response to a high supply voltage condition, the threshold current 129 flows through the PMOS transistor 128, and the NMOS transistor 118 is biased with a lower bias current (e.g., relative to the lower supply voltage condition) by adjusting the bias current 125 by the threshold current amount. For example, adjusted bias current 141 (e.g., IB2-ITHR) flows through the NMOS transistors 118. In this regard, the bias current 125 of the NMOS transistor 118 is deviated by an amount that corresponds to the threshold current 129. In this regard, the bias current 125 may be adjusted proportionally with the supply voltage.

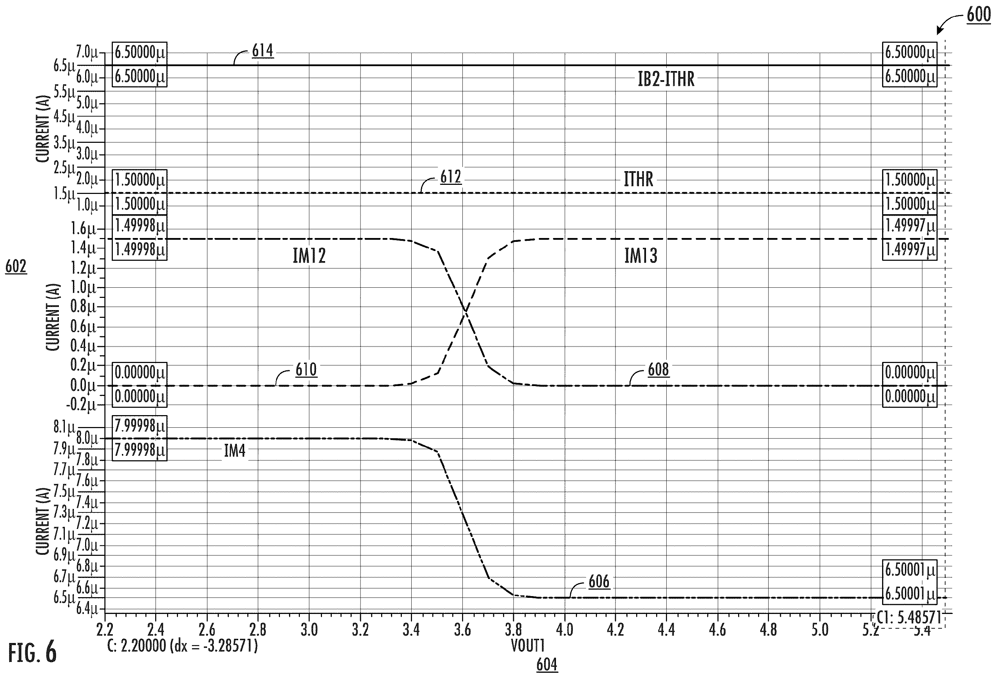

FIG. 6 provides a graphical representation 600 of a behavior of the current steering circuit in accordance with at least one example embodiment of the present disclosure. In particular, FIG. 6 illustrates the current pattern of some components of the class AB amplifier 100 or 200 over a supply voltage sweep/range (2.2V to 5.5V). The Y-axis 602 represents current in Amperes. The X-axis 604 represents the supply voltage in volts. FIG. 6 shows the adjusted bias current 614 (IB2-ITHR such as adjusted bias current 141), threshold current 612 (ITHR such as threshold current 129), current 610 (IM13) of PMOS transistor 128, current 608 (IM12) of PMOS transistor 126, and current 606 (IM4) of NMOS transistor 118.

As shown in FIG. 6, the current 606 of the NMOS transistor 118 and the current 608 of the PMOS transistor 126 follow a similar pattern. As shown in FIG. 6, the current 610 of the PMOS transistor 128 is opposite the pattern of that of the NMOS transistor 118 and the PMOS transistor 126 (e.g., inverse relationship). For example, the current 606 of the NMOS transistor 118 and the current 610 of the PMOS transistor 126 may each be inversely related to the current 610 of the PMOS transistor 128. As shown in FIG. 6, the threshold current 612 and the adjusted bias current 614 may remain substantially constant over the supply voltage sweep.

As shown in FIG. 6, when the class AB amplifier 100 or 200 is in a low supply voltage operation/condition, the current 608 may be substantially the same as the threshold current 612, the current 610 may be about zero, and the current 606 may be substantially the same as the bias current (IB2). As shown in FIG. 6, when the class AB amplifier 100 or 200 moves from the low supply voltage operation/condition to a high supply voltage operation/-condition, the current 608 may be about zero, the current 610 may be substantially the same as the threshold current 612, and the current 606 may be substantially the same as the adjusted bias current 614. For example, in the illustrated example, during low supply voltage operation/condition (or at least a portion thereof), the current 608 and the threshold current 612 may each be about 1.499μA - 1.5μA, and the current 606 may be about 7.99μA. In the illustrated example, during high supply voltage operation/condition (or at least a portion thereof), the current 610 and the threshold current 612 may each be about 1.499μA - 1.5 μA, and the current 606 may be about 6.5μA.

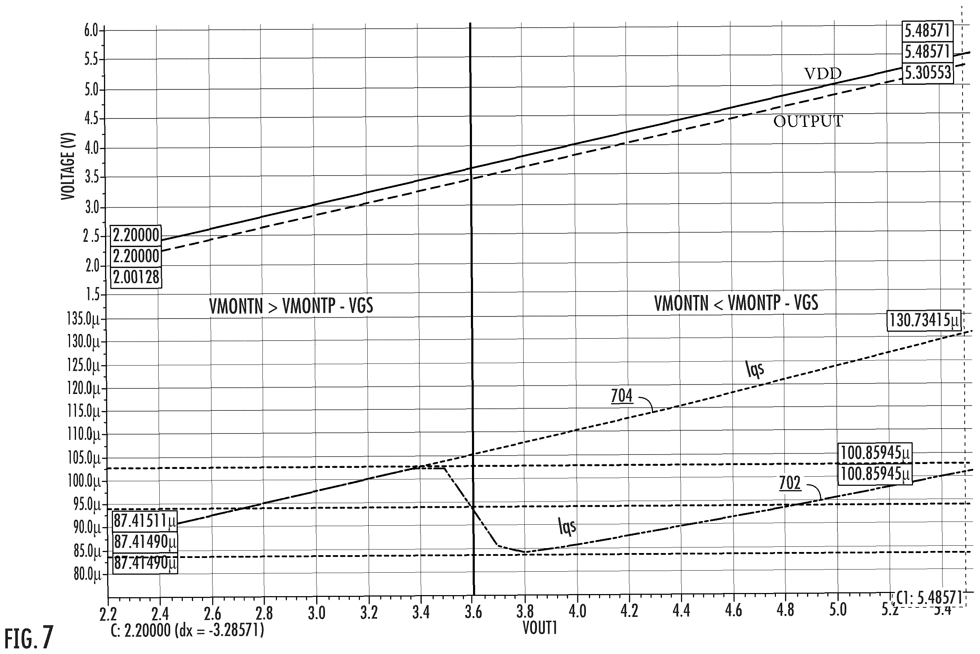

FIG. 7 provides a graphical representation of example quiescent currents over a supply voltage sweep. In particular, FIG. 7 shows a quiescent current behavioral pattern 702 of a class AB amplifier 100 or 200 that includes an optimization circuit 111 according to at least one example embodiment of the present disclosure and a behavioral pattern 704 of a class AB amplifier without such optimization circuit.

As shown in the example test result of FIG. 7, a change in the supply voltage from 2.2V to 5.5V resulted in a quiescent current variation of 43.3 μA. On the other hand, as shown in FIG. 7, a change in the supply voltage from 2.2V to 5.5V resulted in a change of 20μA. In this regard, a quiescent current consumption reduction of 54% was realized/achieved.

**CONCLUSION**

Many modifications and other embodiments of the disclosure set forth herein will come to mind to one skilled in the art to which this disclosure pertains having the benefit of the teachings presented in the foregoing description and the associated drawings. Therefore, it is to be understood that the embodiments are not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single product or packaged into multiple products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. The disclosed embodiments relate primarily to class AB amplifiers, however, one skilled in the art may recognize that such principles may be applied to other types of amplifier. Further, while certain configuration and connections of NMOS and PMOS are described, one skilled in the art may recognize that other configuration and connections may be implemented without departing from the scope of the present disclosure. For example, while the current steering circuit is described as include a pair of PMOS transistors, in some other embodiments, the current steering circuit may include NMOS transistors. Alternative embodiments that result from combining, integrating, and/or omitting features of the embodiment(s) are also within the scope of the disclosure. Accordingly, the scope of protection is not limited by the description set out above. Further, while this detailed description has set forth some embodiments of the present disclosure, the appended claims may cover other embodiments of the present disclosure which differ from the described embodiments according to various modifications and improvements. For example, the appended claims may cover any configuration of class AB amplifiers or other amplifiers that include a current steering circuit.

**Claims**

1. An amplifier (100, 200) comprising:

   an output stage (132, 134) associated with a quiescent current (140, Iqs);
   a set of NMOS transistors (118, 116) comprising a first NMOS transistor (118) and a second NMOS transistor (116) connected together, the first NMOS transistor (118) having a first bias current (125);
   a first set of PMOS transistors (122, 120) comprising a first PMOS transistor (122) and a second PMOS transistor (120), the first PMOS transistor (122) having a second bias current (123); and
   an optimization circuit (111) comprising:

      a current steering circuit (130) that is driven by a threshold current (129), the current steering circuit (130) comprising a second set of PMOS transistors (126, 128); and
      a level shifting device (124) connected to the current steering circuit (130),
      wherein, the current steering circuit (130) is configured to, in response to a first condition of one or more conditions, adjust the first bias current (125) proportionally with a supply voltage (150) by reducing the first bias current (125) by an amount corresponding to the threshold current (129).

2. The amplifier (100, 200) of claim 1, wherein the first bias current (125) is the same as the second bias current (123).

3. The amplifier (100, 200) of any of the previous claims, wherein the level shifting device (124) comprises a third NMOS transistor (124).

4. The amplifier (100, 200) of any of the previous claims, wherein the second set of PMOS transistors (126, 128) comprise a third PMOS transistor (126) and a fourth PMOS transistor (128) connected together.

5. The amplifier (100, 200) of claim 4, wherein a gate of the third PMOS transistor (126) is connected to a source of the third NMOS transistor (124).

6. The amplifier (100, 200) of any of the previous claims, wherein the one or more conditions include a second condition corresponding to a low supply voltage condition.

7. The amplifier (100, 200) of claims 3 and 4, wherein the first condition is determined based on (i) a gate voltage of the third NMOS transistor (124), (ii) a gate voltage of the fourth PMOS transistor (128), and (iii) a gate-source voltage of the third NMOS transistor (124), wherein the first condition is indicative of a high supply voltage condition.

8. The amplifier (100, 200) of claim 7, wherein the set of NMOS transistors (118, 116) generates a first bias voltage (105) corresponding to the gate voltage (133) of the fourth PMOS transistor (128).

9. The amplifier (100, 200) of claim 7 or claim 8, wherein the first set of PMOS transistors (120, 122) generates a second bias voltage (106) corresponding to the gate voltage (135) of the third NMOS transistor (124).

10. The amplifier (100, 200) of any of the previous claims, further comprising a fifth PMOS transistor (112) and a fourth NMOS transistor (114) connected together.

11. The amplifier (100, 200) of claim 10, further comprising a sixth PMOS transistor (110) for receiving an input signal (101), wherein the sixth PMOS transistor (110) is connected to the fifth PMOS transistor (112) and the fourth NMOS transistor (114).

12. The amplifier (100, 200) of any of the previous claims, wherein the output stage (132, 134) comprises a seventh PMOS transistor (132) and a fifth NMOS transistor (134) connected together.

13. The amplifier (100, 200) of any of the previous claims, wherein the amplifier is a class AB amplifier.

14. The amplifier (100, 200) of any of the previous claims, wherein the threshold current (129) is configurable.

15. The amplifier (200) of any of the previous claims, wherein the optimization circuit (111) comprises a second current steering circuit.

16. A device comprising an amplifier (100, 200) according to any of the previous claims.

FIG. 1

FIG. 2

EP 4 753 146 A1

**FIG. 3**

FIG. 4

FIG. 5

FIG. 6

FIG. 7

Europäisches
Patentamt

European
Patent Office

Office européen
des brevets

# EUROPEAN SEARCH REPORT

**Application Number**

EP 25 21 4719

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2009/002070 A1 (SWANSON LELAND SCOTT [US]) 1 January 2009 (2009-01-01) * figures 1-6 * * paragraphs [0001] - [0058] * ----- | 1-16 | INV. H03F1/30 H03F3/30 |
| A | US 2012/056672 A1 (GALAL SHERIF [US] ET AL) 8 March 2012 (2012-03-08) * figures 1-4 * * paragraphs [0001] - [0040] * ----- | 1-16 | |
| A | US 2015/002231 A1 (HUANG LEI [CN] ET AL) 1 January 2015 (2015-01-01) * figures 1-5 * * paragraphs [0001] - [0119] * ----- | 1-16 | |

**TECHNICAL FIELDS SEARCHED (IPC)**

H03F

The present search report has been drawn up for all claims

| Place of search | Date of completion of the search | Examiner |
|---|---|---|
| The Hague | 13 April 2026 | Jespers, Michaël |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 21 4719

This annex lists the patent family members relating to the patent documents cited in the above-mentioned European search report.
The members are as contained in the European Patent Office EDP file on
The European Patent Office is in no way liable for these particulars which are merely given for the purpose of information.

13-04-2026

| Patent document cited in search report | Publication date | Patent family member(s) | | Publication date |
|---|---|---|---|---|
| US 2009002070 A1 | 01-01-2009 | US | 2009002070 A1 | 01-01-2009 |
| | | WO | 2009006093 A2 | 08-01-2009 |
| US 2012056672 A1 | 08-03-2012 | US | 2012056672 A1 | 08-03-2012 |
| | | US | 2013063214 A1 | 14-03-2013 |
| | | US | 2013064398 A1 | 14-03-2013 |
| US 2015002231 A1 | 01-01-2015 | CN | 104253589 A | 31-12-2014 |
| | | US | 2015002231 A1 | 01-01-2015 |

EPO FORM P0459

For more details about this annex : see Official Journal of the European Patent Office, No. 12/82